(19) Europäisches Patentamt
European Patent Office
Office européen des brevets

(11) **EP 4 404 142 A1**

(12) **EUROPEAN PATENT APPLICATION**
published in accordance with Art. 153(4) EPC

(43) Date of publication:
**24.07.2024 Bulletin 2024/30**

(21) Application number: **22883855.3**

(22) Date of filing: **12.10.2022**

(51) International Patent Classification (IPC):
*G06T 11/00* (2006.01)        *G06T 3/40* (2024.01)
*G06N 3/08* (2023.01)

(52) Cooperative Patent Classification (CPC):
**G06N 3/08; G06T 3/40; G06T 11/00**

(86) International application number:
**PCT/KR2022/015361**

(87) International publication number:
**WO 2023/068632 (27.04.2023 Gazette 2023/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.10.2021  KR 20210138141**
**03.12.2021  KR 20210171533**

(71) Applicant: Lightvision Inc.
**Seoul 04793 (KR)**

(72) Inventors:
• JEONG, Jin Ha
  **Yongin-si, Gyeonggi-do 16960 (KR)**
• RA, Moon Soo
  **Bucheon-si, Gyeonggi-do 14539 (KR)**
• LEE, Hea Yun
  **Suwon-si, Gyeonggi-do 16517 (KR)**
• LEE, Hyun Ji
  **Seoul 06074 (KR)**

(74) Representative: **Choi, Jaehyuk**
**BCKIP**
**Siegfriedstraße 8**
**80803 München (DE)**

(54) **DIFFRACTION PATTERN IMAGE CONVERSION SYSTEM AND METHOD FOR INTERCONVERTING VIRTUAL TEM SADP IMAGE AND REAL TEM SADP IMAGE BY USING DEEP LEARNING**

(57)    A system and a method of generating adaptively a TEM SADP image with high discernment according to inputted parameters are disclosed. The system for converting a diffraction pattern image includes a real diffraction pattern image refining unit configured to remove unnecessary information from real diffraction pattern image; a synthetic diffraction pattern generating unit configured to obtain a synthetic diffraction pattern image corresponding to the real diffraction pattern image in which the unnecessary information is removed; and a real-synthetic interconversion algorithm learning unit configured to generate an image belonging to a real diffraction pattern domain from an image belonging to a synthetic diffraction pattern domain or generate an image belonging to the synthetic diffraction pattern domain from an image belonging to the real diffraction pattern domain by using at least one of the real diffraction pattern image in which the unnecessary information is removed and the synthetic diffraction pattern image.

**FIG. 14**

Real diffraction pattern image refining unit — 1400

Synthetic diffraction pattern generating unit — 1402

Sim2Real algorithm learning unit — 1404

EP 4 404 142 A1

**Description**

TECHNICAL FIELD

The present disclosure relates to a system and a method of generating adaptively a TEM SADP image with high discernment according to inputted parameters.

The present disclosure relates to a system and a method of converting a diffraction pattern image for interconverting synthetic TEM SADP image and real TEM SADP image using a deep learning.

BACKGROUND ART

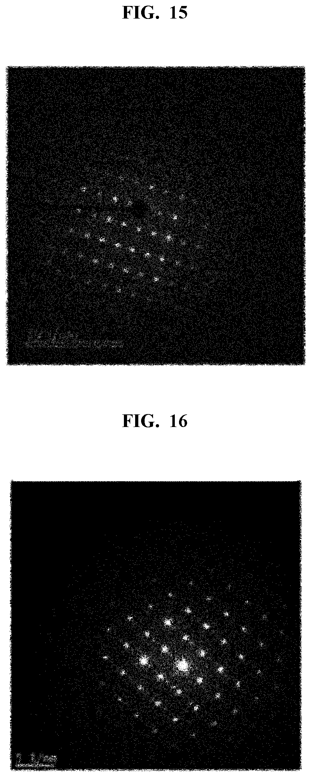

A bright point is shown at a central part of real TEM SADP image because the most amount of an electron beam passes through the central part. Peripheral diffraction points are not well shown because brightness of the bright point is higher than that of the peripheral diffraction points. Accordingly, a beam stopper is used for blocking the brightest point located at the central part as shown in FIG. 15 when the TEM SADP image is photographed. However, conventional simulation program does not consider effect of the beam stopper.

Additionally, various errors, such as an error occurred due to misalign of a direction of the electron beam and a zone axis, an error occurred in an optical system and an error occurred in a process of obtaining a diffraction pattern through an image sensor, e.g. CCD/CMOS, exist in the real TEM SADP image. However, the conventional simulation program does not consider influence by the errors.

Furthermore, quality or error of the TEM SADP image may differ according to a manufacturer of a TEM, but the conventional simulation program does not consider effect due to the difference.

SUMMARY

The present disclosure is to provide a system and a method of generating adaptively a TEM SADP image with high discernment according to inputted parameters.

Additionally, the present disclosure is to provide a system and a method of generating synthetic diffraction pattern image which is usable for a TEM.

Furthermore, the present disclosure is to provide a technique for preventing a ringing effect or a phenomenon that high order Laue Zone (HOLZ) or blurred diffraction point is included in the diffraction pattern image.

Moreover, the present disclosure is to provide a technique for generating a diffraction pattern image by interpreting mathematically parameters inputted by a user.

In addition, the present disclosure is to provide a computing device with rapid processing speed using a parallel processing of a CPU or a GPGPU.

Furthermore, the present disclosure is to provide a technique using an image processing technique such as gamma correction.

Moreover, the present disclosure is to provide a technique using the SADP image generated adaptively depending on inputted parameters.

Additionally, the present disclosure is to provide a technique for preventing a phenomenon that material is broken down because an electron beam is emitted to the material too many times.

Furthermore, the present disclosure is to provide a system and a method of converting a diffraction pattern image for interconverting synthetic TEM SADP image and real TEM SADP image by using a deep learning.

A system for converting a diffraction pattern image according to an embodiment of the present disclosure includes a real diffraction pattern image refining unit configured to remove unnecessary information from real diffraction pattern image; a synthetic diffraction pattern generating unit configured to obtain a synthetic diffraction pattern image corresponding to the real diffraction pattern image in which the unnecessary information is removed; and a real-synthetic interconversion algorithm learning unit configured to generate an image belonging to a real diffraction pattern domain from an image belonging to a synthetic diffraction pattern domain or generate an image belonging to the synthetic diffraction pattern domain from an image belonging to the real diffraction pattern domain by using at least one of the real diffraction pattern image in which the unnecessary information is removed and the synthetic diffraction pattern image.

A system for converting a diffraction pattern image according to another embodiment of the present disclosure includes a real diffraction pattern image refining unit configured to remove unnecessary information from real diffraction pattern image; a synthetic diffraction pattern generating unit configured to obtain a synthetic diffraction pattern image corresponding to the real diffraction pattern image in which the unnecessary information is removed; and an algorithm learning unit configured to generate a diffraction pattern image belonging to real diffraction pattern domain from a diffraction pattern image belonging to a synthetic diffraction pattern domain by using a deep learning algorithm learned with at least one of the real diffraction pattern image and the synthetic diffraction pattern image.

A system for converting a diffraction pattern image according to still another embodiment includes a real diffraction pattern image refining unit configured to remove unnecessary information from real diffraction pattern image; a synthetic diffraction pattern generating unit configured to obtain a synthetic diffraction pattern image corresponding to the real diffraction pattern image in which the unnecessary information is removed; and an algorithm learning unit configured to generate a diffraction pattern image belonging to a synthetic diffraction pattern domain from a diffraction pattern image belonging to a real diffraction pattern domain by using a deep learning algorithm learned with at least one of the real diffraction pattern image and the synthetic diffraction pattern image.

A recording medium readable by a computer recording a program code according to an embodiment of the present embodiment, the program code being used for performing a method includes removing unnecessary information from real diffraction pattern image; generating a synthetic diffraction pattern image corresponding to the real diffraction pattern image in which the unnecessary information is removed; and generating an image belonging to real diffraction pattern domain from an image belonging to a synthetic diffraction pattern domain or generating the image belonging to the synthetic diffraction pattern domain from the image belonging to the real diffraction pattern domain by using at least one of the real diffraction pattern image in which the unnecessary image is removed and the synthetic diffraction pattern image.

A system and a method of generating a TEM SADP image according to an embodiment of the present disclosure may prevent a phenomenon that high order Laue zone (HOLZ) or blurred diffraction point is included in a diffraction pattern and a ringing effect of the diffraction pattern occurred due to a discontinuity point of a light source according to inputted parameters.

A system for converting a diffraction pattern image according to an embodiment of the present disclosure generates a TEM SADP image corresponding to synthetic TEM SADP image, and thus various errors likely to occur in real TEM experiment may be simulated. Here, the generate TEM SADP image is similar to real TEM SADP image.

BRIEF DESCRIPTION OF DRAWINGS

Example embodiments of the present disclosure will become more apparent by describing in detail example embodiments of the present disclosure with reference to the accompanying drawings, in which:

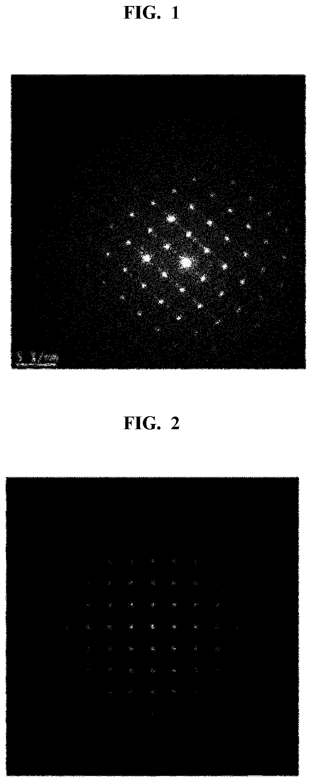

FIG. 1 is a view illustrating an example of real TEM SADP image;
FIG. 2 is a view illustrating synthetic SADP image generated through a JEMS program;

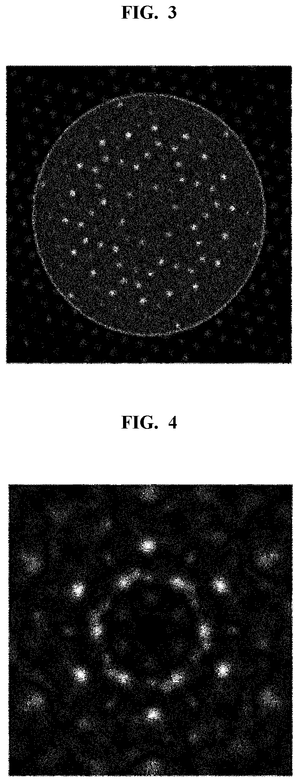

FIG. 3 is a view illustrating an SADP image where HOLZ pattern is included;
FIG. 4 is a view illustrating an SADP image where blurred diffraction point is included;
FIG. 5 is a view illustrating an SADP image to which a ringing effect occurs
FIG. 6 is a block diagram illustrating schematically a system for generating a TEM SADP image according to an embodiment of the present disclosure;
FIG. 7 is a view illustrating an SADP image to which a ringing effect does not occur generated by using a method of generating the TEM SADP image of the present disclosure;
FIG. 8 is a view illustrating an example of lattice constant of material included in a cubic system;
FIG. 9 is a view illustrating an example of lattice constant of material included in a hexagonal system;
FIG. 10 is a view illustrating relation among an electron beam, Eward sphere, reciprocal lattice and diffraction pattern;
FIG. 11 is a view illustrating unit lattice before aligned and unit lattice after aligned;
FIG. 12 is a view illustrating a slab-type sample generated by using unit lattice aligned with a zone axis according to an embodiment of the present disclosure;
FIG. 13 is a view illustrating an example of a diffraction pattern generated by the system for generating the TEM SADP image according to the present disclosure;
FIG. 14 is a view illustrating a system for interconverting real TEM SADP image and synthetic TEM SADP image according to an embodiment of the present disclosure;
FIG. 15 is a view illustrating a process of blocking a bright point located at a central part of an image by using a beam stopper;
FIG. 16 is a view illustrating an example of real TEM SADP image in which scale information is shown;
FIG. 17 is a view illustrating real TEM SADP image in which the scale information is erased;
FIG. 18 is a view illustrating an example of synthetic TEM SADP image generated through a JEMS program;
FIG. 19 is a view illustrating an example of a TEM SADP image similar to real TEM SADP image from synthetic TEM SADP image; and
FIG. 20 is a view illustrating a real-synthetic interconversion algorithm according to an embodiment of the present disclosure.

DETAILED DESCRIPTION

In the present specification, an expression used in the singular encompasses the expression of the plural, unless it has a clearly different meaning in the context. In the present specification, terms such as "comprising" or "including," etc., should not be interpreted as meaning that all of the elements or operations are necessarily included. That is, some of the elements or operations may not be included, while other additional elements or operations may be further included. Also, terms such as "unit," "module," etc., as used in the present specification may refer to a part for processing at least one function or action and may be implemented as hardware, software, or a combination of hardware and software.

The present disclosure relates to a system and a method of generating adaptively a TEM (Transmission Electron Microscope) SADP (Selected Area Diffraction Pattern) image with high discernment according to inputted parameters. The system may generate excellent TEM SADP image with discernment, a ringing effect of a diffraction pattern due to a discontinuity point of a light source and a phenomenon that high order Laue zone (HOLZ) or blurred diffraction point is included in the diffraction pattern not being occurred to the TEM SADP image.

An SADP image is obtained by emitting an electron beam to material through a TEM to detect feature of the material, but the material may be broken down if the electron beam is emitted to the material too many times. Accordingly, the system may generate an SADP image by using a program without emitting really the electron beam to the material so that the material is not broken down. The generated SADP image may be used in various fields.

Hereinafter, various embodiments of the present disclosure will be described in detail with reference to accompanying drawings.

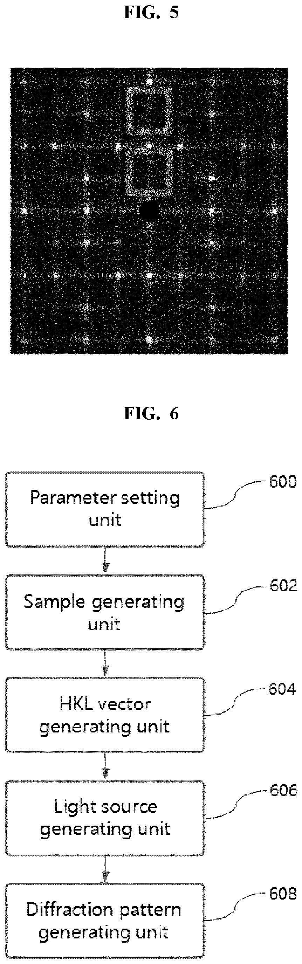

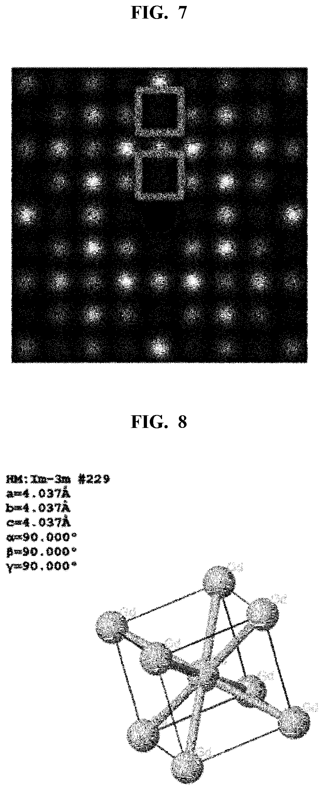

FIG. 6 is a block diagram illustrating schematically a system for generating a TEM SADP image according to an embodiment of the present disclosure, and FIG. 7 is a view illustrating an SADP image to which a ringing effect does not occur generated by using a method of generating the TEM SADP image of the present disclosure.

In FIG. 6, the system for generating a TEM SADP image of the present embodiment may generate adaptively an SADP image according to inputted parameters, the ringing effect of a diffraction pattern and a phenomenon that HOLZ or blurred diffraction point is included in the diffraction pattern not being occurred to the SADP image.

The system may include a parameter setting unit 600, a sample generating unit 602, an HKL vector generating unit 604, a light source generating unit 606, a diffraction pattern generating unit 608 and a controller (not shown) for controlling their operation. Here, the system may be embodied with one device, e.g., be a server, and it may be referred to as a computing device.

The parameter setting unit 600 may set parameters for generating the SADP image. For example, the parameter setting unit 600 may set the parameters through user's input.

In an embodiment, the parameter setting unit 600 may set parameters such as lattice constant, relative location of atom in unit lattice, a zone axis, wavelength and intensity of an electron beam, a distance to a camera, size of a diffraction pattern image and so on. Every parameter may be inputted by the user or the other parameter may be automatically generated if the user inputs a part of the parameters.

The sample generating unit 602 may generate a slab-type sample by using a parameter about the relative location of atom in unit lattice and a parameter about the zone axis. Here, the slab may have a shape of thin plate. Of course, the sample is not limited as the slab-type sample.

The HKL vector generating unit 604 may generate a reciprocal lattice vector meeting with synthetic Eward sphere. Here, the reciprocal lattice may be a parameter generated automatically by using specific program according to the unit lattice set by the parameter setting unit 600.

The light source generating unit 606 may calculate relative brightness of an electron beam reached to each of atoms in the sample.

The diffraction pattern generating unit 608 may generate synthetic SADP image by accumulating diffractions generated by interaction among every atom and every electron in the sample. In this time, the set parameters, the reciprocal lattice vector, relative brightness of the electron beam reached to the atom, etc. may be used.

Briefly, the system of generating the TEM SADP image of the present embodiment generates adaptively synthetic SADP image in response to various inputted parameters. Here, the ringing effect and the phenomenon that the HOLZ pattern or the blurred diffraction point is included in the diffraction pattern may not be occurred to the synthetic SADP image.

Additionally, the system may generate rapidly the SADP image by using parallel processing of a CPU or a GPGPU.

That is, the system may generate rapidly many synthetic SADP images. Here, the generated SADP images may be substantially identical to real SADP image.

In above description, specific parameters are mentioned as parameters inputted by the user. However, the parameter is not limited as long as the sample is generated by using the parameters inputted by the user.

That is, the system of generating the TEM SADP image may include a sample generating unit for generating the slab-type sample using the parameters inputted by the user, a light source generating unit for calculating the brightness of the electron beam reached to the atom in the sample by using inputted shape and intensity of the light source and the diffraction pattern generating unit for generating synthetic diffraction pattern image by using the calculated brightness of the electron beam.

On the other hand, the reciprocal lattice vector, the brightness of the electron beam and the diffraction pattern may be generated by applying mathematically the parameters inputted by the user. This will be described below.

In the above description, the user inputs the parameters to generate the TEM SADP image. However, the system may extract parameters from real SADP image and generate synthetic TEM SADP image using the extracted parameters. That is, the system may generate multiple synthetic TEM SADP images based on the real SADP image.

Furthermore, the number of layers of the slab, the reciprocal lattice vector and the brightness of the electron beam, etc. are not fixed, but they may be adaptively changed depending on the parameters inputted by the user or the parameters extracted from the real SADP image. This will be described below.

Hereinafter, a process of generating the TEM SADP image will be described in detail with reference to accompanying drawings.

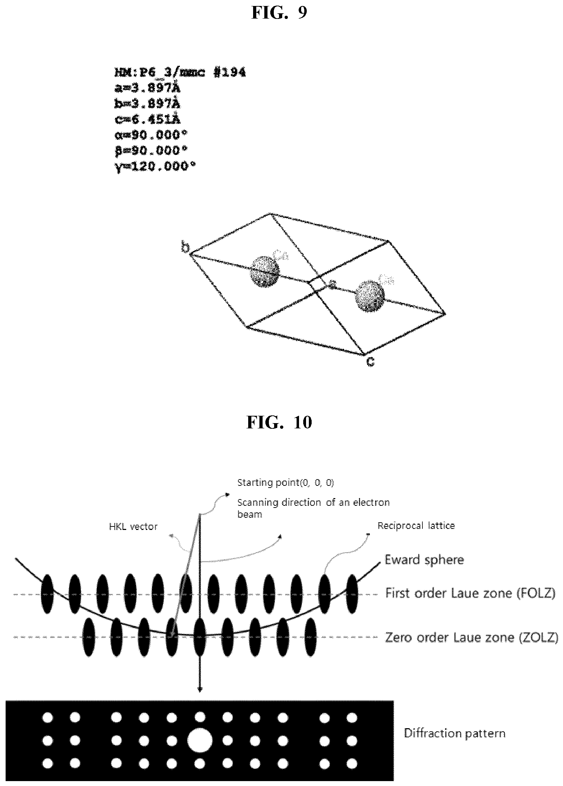

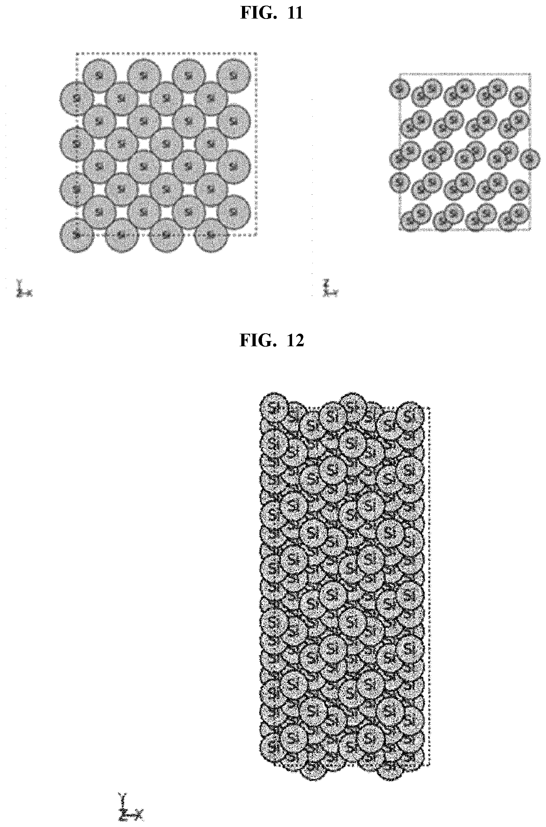

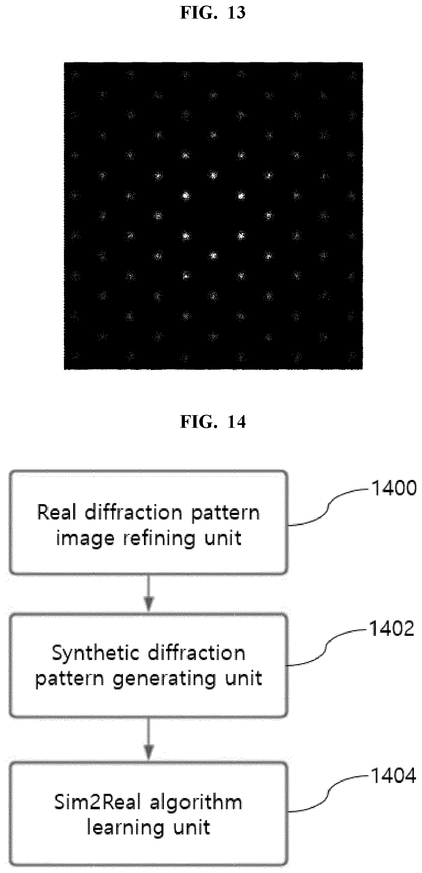

FIG. 8 is a view illustrating an example of lattice constant of material included in a cubic system. FIG. 9 is a view illustrating an example of lattice constant of material included in a hexagonal system, FIG. 10 is a view illustrating relation among an electron beam, Eward sphere, reciprocal lattice and diffraction pattern, and FIG. 11 is a view illustrating unit lattice before aligned and unit lattice after aligned. FIG. 12 is a view illustrating a slab-type sample generated by using unit lattice aligned with a zone axis according to an embodiment of the present disclosure, and FIG. 13 is a view illustrating an example of a diffraction pattern generated by the system for generating the TEM SADP image according to the present disclosure.

The parameter setting unit 600 may set parameters such as lattice constant, relative location of atom in unit lattice, a zone axis, wavelength and intensity of an electron beam, distance to a camera, size of a diffraction pattern image and so on. The parameters may be inputted by the user or be extracted from real SADP image.

Here, the lattice constant and the relative location of atom in the unit lattice may be inputted in CIF (Crystallography Information File) type, FHI-aims type or XYZ type.

The sample generating unit 602 may generate the slab-type sample by using inputted parameter about the lattice constant, inputted parameter about the relative location of atom in the unit lattice and inputted parameter about the zone axis.

Particularly, the lattice constant may comprise six parameters which include a, b, c, $\alpha$, $\beta$ and $\gamma$, wherein a, b and c correspond to size of a lattice vector and $\alpha$, $\beta$ and $\gamma$ correspond to angles between the lattice vectors. Material belongs to a cubic system if a=b=c, $\alpha = \beta = \gamma = 90°$ as shown in FIG. 8, and the material belongs to a hexagonal system if a=b≠c, $\alpha = \beta = 90°$, $\gamma = 120°$ as shown in FIG. 9.

The relative location of atom in the unit lattice may be expressed in following table 1 when a three-dimensional space in the unit lattice is expressed in the range of 0 to 1.

[Table 1]

| (relative location of atom in the unit lattice of LiAl material belonging to the cubic system) | | |
|---|---|---|
| Atomic symbol | Relative location | | |
| | x axis | y axis | z axis |
| Li | 0.0000 | 0.0000 | 0.5000 |
| Al | 0.0000 | 0.0000 | 0.0000 |

The sample generating unit 602 may generate the slab-type sample shown in FIG. 12 by aligning the unit lattice so that a lattice surface corresponding to the zone axis is vertical to a direction of the electron beam as shown in FIG. 11. Here, the slab-type sample may have a structure that unit lattices are disposed in platelike shape. The material in cubic system is generated in FIG. 12, but a sample in hexagonal system may be generated through the same process. Rodrigues formula may be used for aligning the direction of the electron beam in three-dimensional vector with the zone axis.

In an embodiment, the phenomenon that HOLZ or blurred diffraction point is included in the diffraction pattern may be prevented by determining adaptively the number of layers of the slab according to the inputted parameter about the lattice constant and the parameter about the zone axis.

That is, the sample generating unit 602 may determine adaptively the number of layers of the slab according to the inputted parameter about the lattice constant and the inputted parameter about the zone axis, to prevent the phenomenon that the HOLZ or blurred diffraction point is included in the diffraction pattern. Unit lattices may be aligned in the layers of the slab. As a result, the number of the layers of the slab may differ according to the parameters inputted by the user though the same material is used.

The HKL vector generating unit 604 may generate a reciprocal lattice vector meeting with synthetic Eward sphere as shown in FIG. 10. Diffraction may occur at a reciprocal lattice meeting with the Eward sphere, and thus the reciprocal lattice at which the diffraction occurs may be detected to calculate the diffraction pattern. Here, the reciprocal lattice may be parameters generated automatically by using specific program or equations according to the unit lattice set by the parameter setting unit 600.

Particularly, the HKL vector generating unit 604 may calculate a reciprocal lattice vector h(x,y), k(x,y), l(x,y) by using an image coordinate (x, y) separated from a starting point at which the electron beam locates by predetermined distance (d) and a wavelength (λ) of the electron beam as shown in following equation 1 and equation 2.

【Equation 1】

$$\chi = \sqrt{\left(\frac{x}{\lambda d}\right)^2 + \left(\frac{y}{\lambda d}\right)^2 + \left(\frac{1}{\lambda}\right)^2}$$

【Equation 2】

$$h(x,y) = \frac{x}{\lambda^2 d\chi}$$

$$k(x,y) = \frac{y}{\lambda^2 d\chi}$$

$$l(x,y) = \frac{1}{\lambda} - \frac{1}{\lambda^2 \chi}$$

As shown in equation 1, the HKL vector generating unit 604 may calculate $\chi$ if the image coordinate (x, y), the wavelength (λ ) and the distance (d) from the starting point at which the electron beam locates are known. The reciprocal lattice vector [h(x,y), k(x,y), l(x,y)] may be automatically calculated by using the calculated X .

The light source generating unit 606 may calculate the brightness of the electron beam reached to each of atoms in the sample by using inputted shape and intensity of a light source. Here, the shape of the light source may be flat based on a lattice surface vertical to the direction of the electron beam or have 2D Gaussian shape.

The brightness of the electron beam reached to each of atoms is shown in following equation 3 if the shape of the light source is flat when 3D location of the atom in the sample is ($x_j$, $y_j$, $z_j$).

【Equation 3】

$$I(x_j, y_j, z_j) = I_0$$

Here, $I_O$ means intensity of the light source.

The brightness of the electron beam reached to each of atoms is shown in following equation 4 if the light source has 2D Gaussian shape.

【Equation 4】

$$I(x_j, y_j, z_j) = I_0 \exp\left(-\left(\frac{(x - x_j)^2}{\sigma_x^2} + \frac{(y - y_j)^2}{\sigma_y^2}\right)\right)$$

Here, $\sigma_x$ means a standard deviation at x axis, and $\sigma_y$ means a standard deviation at y axis.

The brightness of the electron beam reached to each of atoms is shown in following equation 5 if the light source has 3D Gaussian shape.

【Equation 5】

$$I(x_j, y_j, z_j) = I_0 \exp\left(-\left(\frac{(x - x_j)^2}{\sigma_x^2} + \frac{(y - y_j)^2}{\sigma_y^2} + \frac{(z - z_j)^2}{\sigma_z^2}\right)\right)$$

Here, $\sigma_z$ means a standard deviation at z axis.

The light source generating unit 606 may use 3D Gaussian to generate continuous shape of the light source. In this case, a discontinuity point may not be occurred to an edge of the sample by setting $3\sigma$ in Gaussian to have values smaller than a width, a length and a height of the sample.

In another embodiment, the light source generating unit 606 may remove a discontinuity point occurred in a width direction and a longitudinal direction of the sample by using 2D Gaussian or remove a discontinuity point occurred in a height direction of the sample by using an exponential decay function when the 2D Gaussian and the exponential decay function are simultaneously used.

On the other hand, the light source generating unit 606 may simulate the brightness lowered according as the electron beam passes through the sample by applying the exponential decay based on a direction of the electron beam. The light source to which the exponential decay is applied may be defined in following equation 6.

【Equation 6】

$$I'(x_j, y_j, z_j) = I(x_j, y_j, z_j) \exp(-\lambda_d z_j)$$

Here, $\lambda_d$ means a parameter of the exponential decay.

Size and shape of the light source generated by the light source generating unit 606 may be adaptively changed depending on inputted size of the slap and inputted size of the diffraction pattern image, etc., and thus the ringing effect of the diffraction pattern occurred from the discontinuity point of the light source may be prevented. This is shown in FIG. 7. That is, the light source generating unit 606 may change adaptively the size and the shape of the light source according to the inputted size of the slab and the inputted size of the diffraction pattern image, to prevent the ringing effect of the diffraction pattern.

The diffraction pattern generating unit 608 may calculate accumulated diffraction pattern (F(h,k,l)) by using the reciprocal lattice vector [h(x,y), k(x,y), l(x,y)] calculated by the HKL vector generating unit 604, location of atom in the sample and the brightness of the electron beam (I(xj,yj,zj)) obtained by the light source generating unit 606 as shown in following equation 7.

【Equation 7】

$$F(h,k,l) = \sum_{j=1}^{n} f_{0j}(h,k,l) I(x_j,y_j,z_j) \cos\{2\pi(hx_j + ky_j + lz_j)\}$$
$$+ i \sum_{j=1}^{n} f_{0j}(h,k,l) I(x_j,y_j,z_j) \sin\{2\pi(hx_j + ky_j + lz_j)\}$$

Here, $f_{0j}(h,k,l)$ means jth scattering factor of atom. The scattering factor may differ according to kind of the atom.

Subsequently, the diffraction pattern generating unit 608 may calculate maximum value of the accumulated diffraction pattern and generate the diffraction pattern image by normalizing linearly the accumulated diffraction pattern based on the calculated maximum value.

In another embodiment, the diffraction pattern generating unit 608 may generate the diffraction pattern image by normalizing nonlinearly the accumulated diffraction pattern using an image process technique such as a gamma correction. Here, diffraction generated from interaction of atom and electron included in the sample may be independently calculated by the diffraction pattern generating unit 608, and thus an SADP image may rapidly calculated by using parallel processing of a CPU or a GPGPU (General Purpose computing on Graphics Processing Unit). The SADP image is shown in FIG. 13. As shown in FIG. 13, the ringing effect and the phenomenon that the HOLZ or the diffraction pattern is included in the diffraction pattern don't occur to the SADP image.

On the other hand, the diffraction pattern generating unit 608 may apply accumulated diffraction values to various functions to generate the SADP image. For example, the diffraction pattern generating unit 608 may generate the diffraction pattern image by applying a linear function or generate the diffraction pattern image by using a function used for gamma correction such as $Vo=AV_{i\gamma}$.

Briefly, the system for generating the SADP image of the present embodiment may generate the SADP image by using the reciprocal lattice vector, the location of atom in the sample and the brightness of the electron beam, wherein the ringing effect and the phenomenon that the HOLZ or the blurred diffraction point is included in the diffraction pattern are not occurred to the SADP image.

Hereinafter, a system and a method of interconverting real TEM SADP image and synthetic TEM SADP image by using a deep learning will be described in detail with reference to accompanying drawings.

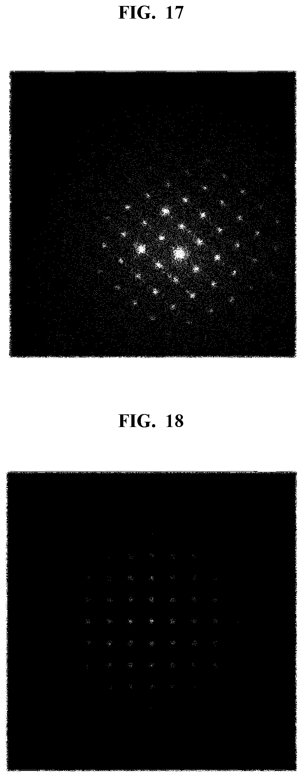

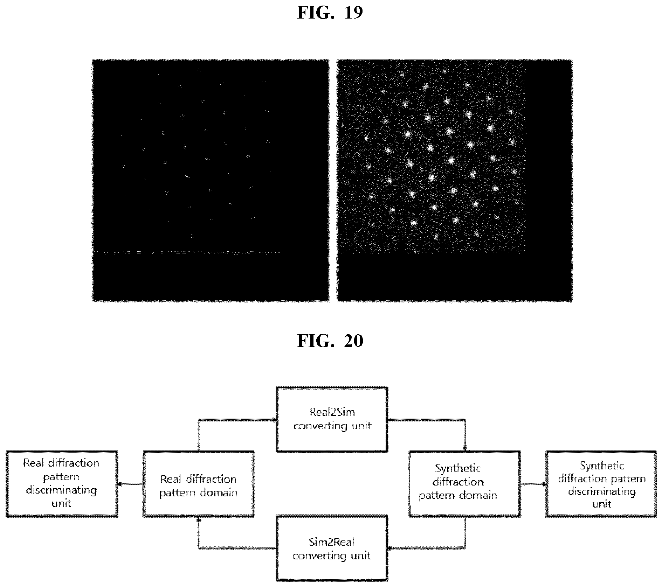

FIG. 14 is a view illustrating a system for interconverting real TEM SADP image and synthetic TEM SADP image according to an embodiment of the present disclosure, FIG. 15 is a view illustrating a process of blocking a bright point located at a central part of an image by using a beam stopper, and FIG. 16 is a view illustrating an example of real TEM SADP image in which scale information is shown. FIG. 17 is a view illustrating real TEM SADP image in which the scale information is erased, FIG. 18 is a view illustrating an example of synthetic TEM SADP image generated through a JEMS program, and FIG. 19 is a view illustrating an example of a TEM SADP image similar to real TEM SADP image from synthetic TEM SADP image. FIG. 20 is a view illustrating a real-synthetic interconversion algorithm according to an embodiment of the present disclosure.

A system for interconverting real TEM SADP image and synthetic TEM SADP image of the present embodiment includes a real diffraction pattern image refining unit 1400, a synthetic diffraction pattern generating unit 1402, a real-synthetic interconversion algorithm learning unit 1404 and a controller for controlling their operation.

The real diffraction pattern image refining unit 1400 may remove unnecessary part from real TEM SADP image, e.g. real TEM SADP image collected through an experiment or real TEM SADP image collected through a webpage.

For example, the real diffraction pattern image refining unit 1400 may remove annotation information, scale information, lattice surface index information, etc. added for recording additional information in the real TEM SADP image as shown in FIG. 15.

In an embodiment, the real diffraction pattern image refining unit 1400 may erase the annotation information from the real TEM SADP image and compose background on an erased area by using a commercial image processing program such as a Photoshop or a hole-filling algorithm for filling a damaged part of an image. An SADP image obtained through this process is shown in FIG. 17. Of course, a program is not limited as long as the program fills the erased area.

In another embodiment, the real diffraction pattern image refining unit 1400 may erase the scale information from real TEM SADP image in which the scale information is marked as shown in FIG. 16 and generate an SADP image by composing background on an erased area through the hole-filling algorithm, etc. as shown in FIG. 17.

The synthetic diffraction pattern generating unit 1402 may generate synthetic TEM SADP image corresponding to the real TEM SADP image by using a TEM SADP simulation program such as JEMS, QSTEM, abTEM, Ladyne Software Suite, SingleCrystal, Condor, etc. based on inputted parameter about the lattice constant and inputted parameter about the unit lattice. Here, the parameter about the lattice constant and the parameter about the unit lattice may be inputted by the user or be extracted from the real TEM SADP image.

Synthetic TEM SADP image generated by using a JEMS program is shown in FIG. 18 when information concerning the lattice constant and the unit lattice is provided in a CIF (Crystallography Information File) type, a FHI-aims type, a XYZ type. In this time, a method of generating an SADP image using one program may reduce confusion resulted from diversity of data in a learning process compared to a method of generating an SADP image using various programs because the generated synthetic SADP image is used for following learning of real-synthetic interconversion algorithm.

For example, the synthetic diffraction pattern generating unit 1402 may generate synthetic TEM SADP images corresponding to real TEM SADP image in which unnecessary part is removed by using the same JEMS program and may not use another program for generating the synthetic TEM SADP image.

In another embodiment, the synthetic diffraction pattern generating unit 1402 may select synthetic SADP image corresponding to the real TEM SADP image of synthetic TEM SADP images generated in FIG. 6 to FIG. 13.

In another aspect, the synthetic diffraction pattern generating unit 1402 may generate synthetic TEM SADP image corresponding to the real TEM SADP image through methods mentioned in FIG. 6 to FIG. 13.

Here, the synthetic diffraction pattern generating unit 1402 may include a sample generating unit for generating a sample by using at least one of a parameter about the lattice constant, a parameter about the relative location of atom in the unit lattice and a parameter about the zone axis, a vector generating unit for generating a reciprocal lattice vector corresponding to the unit lattice, a light source generating unit for calculating brightness of an electron beam reached to atom in the generated sample, a diffraction pattern generating unit for generating synthetic diffraction pattern image (TEM SADP image) using the generated reciprocal lattice vector, location of atom in the sample and the calculated brightness of the electron beam and a selection unit for selecting synthetic diffraction pattern image corresponding to the real diffraction pattern image of the generated synthetic diffraction pattern image.

The real-synthetic interconversion algorithm learning unit 1404 may learn a real-synthetic interconversion algorithm for generating an image belonging to a real diffraction pattern domain from an image belonging to a synthetic diffraction pattern domain or generating the image belonging to the synthetic diffraction pattern domain from an image belonging to the real diffraction pattern domain by using the real SADP image and the synthetic SADP image.

Subsequently, the real-synthetic interconversion algorithm learning unit 1404 may generate an SADP image belonging to the real diffraction pattern domain from an SADP image belonging to the synthetic diffraction pattern domain by using a deep learning model, i.e. a deep learning technique. For example, the real-synthetic interconversion algorithm learning unit 1404 may generate the SADP image shown in a right side in FIG. 19 from the synthetic SADP image shown in a left side in FIG. 19, the generated SADP image being similar to the real SADP image.

In this time, an algorithm requiring a pair of images belonging to two domains may be used if a synthetic diffraction pattern image having the same location of a diffraction point as real diffraction pattern is prepared. Whereas, an algorithm not requiring a pair of images belonging to two domains may be used if only one of the real diffraction pattern image and the synthetic diffraction pattern image is prepared.

The real-synthetic interconversion algorithm may generate the TEM SADP image similar to the real TEM SADP image considering effect of various errors included in the real TEM SADP image and effect of a beam stopper, through above process.

In another embodiment, the real-synthetic interconversion algorithm learning unit 1404 may generate the SADP image belonging to the real diffraction pattern domain from the SADP image belonging to the synthetic diffraction pattern domain and generate the SADP image belonging to the synthetic diffraction pattern domain from the SADP image belonging to the real diffraction pattern domain. An input will be real TEM SADP image if a deep learning application is created based on the TEM SADP image.

Here, a deep learning model learned with the SADP image belonging to the synthetic diffraction pattern domain may be used if inputted SADP image belonging to the real diffraction pattern domain is converted into the SADP image belonging to the synthetic diffraction pattern domain.

In FIG. 20, the real-synthetic interconversion algorithm learning unit 1404 may include a real diffraction pattern discriminating unit, a synthetic diffraction pattern discriminating unit, a Real2Sim converting unit and a Sim2Real converting unit.

The real diffraction pattern discriminating unit learns a deep learning model for discriminating a synthetic diffraction pattern converted through the Sim2Real converting unit from a diffraction pattern photographed through real TEM, the synthetic diffraction pattern being similar to the real diffraction pattern. Here, the synthetic diffraction pattern and the diffraction pattern photographed through the real TEM belong to the real diffraction pattern domain.

The synthetic diffraction pattern discriminating unit learns a deep learning model for discriminating real diffraction pattern converted through the Real2Sim converting unit from a synthetic diffraction pattern generated through a simulation, the real diffraction pattern being similar to the synthetic diffraction pattern. Here, the real diffraction pattern and the synthetic diffraction pattern generated through the simulation belong to the synthetic diffraction pattern domain.

The Real2Sim converting unit learns a deep learning model for converting the image belonging to the real diffraction pattern domain to the image belonging to the synthetic diffraction pattern domain. Here, an object of the Real2Sim converting unit is to generate very similar image so that the synthetic diffraction pattern discriminating unit can't discriminate an image generated thereby from the image generated through the simulation.

The Sim2Real converting unit learns a deep learning model for converting the image belonging to the synthetic diffraction pattern domain to the image belonging to the real diffraction pattern domain. Here, an object of the Sim2Real converting unit is to generate very similar image so that the real diffraction pattern discriminating unit can't discriminate an image generated thereby from the image photographed through real TEM.

Four elements in the real-synthetic interconversion algorithm learning unit 1404 affects to one another and learns a deep learning model performable well its object. Finally, the four elements may interconvert smoothly the image belonging to the real diffraction pattern domain and the image belonging to the synthetic diffraction pattern domain.

Since much time is required for obtaining real TEM SADP image through an experiment, a plenty of learning data set may be easily obtained if the deep learning mode learned with the SADP image belonging to the synthetic diffraction pattern domain is applied to real application. As a result, the application with high performance may be constructed.

Briefly, the system for interconverting the real TEM SADP image and the synthetic TEM SADP image may remove unnecessary information from collected real TEM SADP image, generate the synthetic TEM SADP image corresponding to the real TEM SADP image in which the unnecessary information is removed, and learn the real-synthetic interconversion algorithm by using the generated synthetic TEM SADP image and the real TEM SADP image. Here, the real-synthetic interconversion algorithm may generate the SADP image belonging to the real diffraction pattern domain from the SADP image belonging to the synthetic diffraction pattern domain, or generate the SADP image belonging to the synthetic diffraction pattern domain from the SADP image belonging to the real diffraction pattern domain.

Various errors occurred in real TEM experiment may be simulated by generating the TEM SADP image from the synthetic TEM SADP image, the TEM SADP image being similar to the real TEM SADP image.

Synthetic data generated through the simulation may be efficiently used for learning the deep learning model by reducing difference between the real TEM SADP image and the synthetic TEM SADP image through the real-synthetic interconversion algorithm when a deep learning application is created by using the TEM SADP image.

Components in the embodiments described above can be easily understood from the perspective of processes. That is, each component can also be understood as an individual process. Likewise, processes in the embodiments described above can be easily understood from the perspective of components.

Also, the technical features described above can be implemented in the form of program instructions that may be performed using various computer means and can be recorded in a computer-readable medium. Such a computer-readable medium can include program instructions, data files, data structures, etc., alone or in combination. The program instructions recorded on the medium can be designed and configured specifically for the present invention or can be a type of medium known to and used by the skilled person in the field of computer software. Examples of a computer-readable medium may include magnetic media such as hard disks, floppy disks, magnetic tapes, etc., optical media such as CD-ROM's, DVD's, etc., magneto-optical media such as floptical disks, etc., and hardware devices such as ROM, RAM, flash memory, etc. Examples of the program of instructions may include not only machine language codes produced by a compiler but also high-level language codes that can be executed by a computer through the use of an interpreter, etc. The hardware mentioned above can be made to operate as one or more software modules that perform the actions of the embodiments of the invention, and vice versa.

The embodiments of the invention described above are disclosed only for illustrative purposes. A person having ordinary skill in the art would be able to make various modifications, alterations, and additions without departing from the spirit and scope of the invention, but it is to be appreciated that such modifications, alterations, and additions are encompassed by the scope of claims set forth below.

**Claims**

1. A system for converting a diffraction pattern image comprising:

   a real diffraction pattern image refining unit configured to remove unnecessary information from real diffraction pattern image;
   a synthetic diffraction pattern generating unit configured to obtain a synthetic diffraction pattern image corresponding to the real diffraction pattern image in which the unnecessary information is removed; and
   a real-synthetic interconversion algorithm learning unit configured to generate an image belonging to a real diffraction pattern domain from an image belonging to a synthetic diffraction pattern domain or generate an image belonging to the synthetic diffraction pattern domain from an image belonging to the real diffraction pattern domain by using at least one of the real diffraction pattern image in which the unnecessary information is removed and the synthetic diffraction pattern image.

**2.** The system of claim 1, wherein the diffraction pattern image is a TEM (transmission electron microscope) SADP (selected area diffraction pattern) image.

**3.** The system of claim 2, wherein the unnecessary information is information concerning annotation, scale or index.

**4.** The system of claim 3, wherein the real diffraction pattern image refining unit detects the unnecessary information from the real diffraction pattern image and fills an area in which the unnecessary information locates using peripheral information of the detected unnecessary information through a hole-filling algorithm.

**5.** The system of claim 2, wherein the synthetic diffraction pattern generating unit uses a TEM SADP simulation program, and wherein the TEM SADP simulation program generates a synthetic TEM SADP image corresponding to the real TEM SADP image based on inputted lattice constant and inputted unit lattice.

**6.** The system of claim 5, wherein information concerning the lattice constant and the unit lattice is provided in CIF (crystallography information file) type, FHI-aims type or XYZ type.

**7.** The system of claim 2, wherein the synthetic diffraction pattern generating unit includes:

a sample generating unit configured to generate a sample by using at least one of a parameter about lattice constant, a parameter about relative location of atom in unit lattice and a parameter about a zone axis;
a vector generating unit configured to generate a reciprocal lattice vector corresponding to the unit lattice;
a light source generating unit configured to calculate brightness of an electron beam reached to atom in the generated sample;
a diffraction pattern generating unit configured to generate synthetic diffraction pattern image by using the generated reciprocal lattice vector, location of atom in the sample and the calculated brightness of the electron beam; and
a selection unit configured to select a synthetic diffraction pattern image corresponding to the real diffraction pattern image of the generated synthetic diffraction pattern image.

**8.** The system of claim 7, wherein the sample generating unit determines adaptively the number of layers of a slab according to the parameter about the lattice constant and the parameter about the zone axis of the inputted parameters so that a phenomenon that high order Laue Zone (HOLZ) or blurred diffraction point is included in a diffraction pattern are prevented, and
the light source generating unit changes adaptively a shape and intensity of the light source according to inputted size of the slab or inputted size of the diffraction pattern image so that a ringing effect of the diffraction pattern occurred from a discontinuity point of the light source is prevented.

**9.** The system of claim 2, wherein the real-synthetic interconversion algorithm learning unit generates a diffraction pattern image belonging to a real diffraction pattern domain from a diffraction pattern image belonging to a synthetic diffraction pattern domain by using a deep learning model.

**10.** The system of claim 9, wherein the real-synthetic interconversion algorithm learning unit generates the diffraction pattern image belonging to the real diffraction pattern domain from the diffraction pattern image belonging to the synthetic diffraction pattern domain by using specific algorithm when the real diffraction pattern image and the synthetic diffraction pattern image are prepared.

**11.** The system of claim 2, wherein the real-synthetic interconversion algorithm learning unit includes:

a Real2Sim converting unit;
a Sim2Real converting unit;
a real diffraction pattern discriminating unit configured to learn a deep learning model for discriminating a synthetic diffraction pattern image converted through the Sim2Real converting unit from a diffraction pattern image photographed through real TEM, the synthetic diffraction pattern image being similar to the real diffraction pattern image; and
a synthetic diffraction pattern discriminating unit configured to learn a deep learning model for discriminating real diffraction pattern image converted through the Real2Sim converting unit from a synthetic diffraction pattern image generated through a simulation, the real diffraction pattern image being similar to the synthetic diffraction pattern,

and wherein the Real2Sim converting unit learns a deep learning model for converting an image belonging to the real diffraction pattern domain to an image belonging to the synthetic diffraction pattern domain, and the Sim2Real converting unit learns a deep learning model for converting the image belonging to the synthetic diffraction pattern domain to the image belonging to the real diffraction pattern domain.

12. A system for converting a diffraction pattern image comprising:

a real diffraction pattern image refining unit configured to remove unnecessary information from real diffraction pattern image;
a synthetic diffraction pattern generating unit configured to obtain a synthetic diffraction pattern image corresponding to the real diffraction pattern image in which the unnecessary information is removed; and
an algorithm learning unit configured to generate a diffraction pattern image belonging to real diffraction pattern domain from a diffraction pattern image belonging to a synthetic diffraction pattern domain by using a deep learning algorithm learned with at least one of the real diffraction pattern image and the synthetic diffraction pattern image.

13. The system of claim 12, wherein the algorithm learning unit generates the diffraction pattern image belonging to the real diffraction pattern domain from the diffraction pattern image belonging to the synthetic diffraction pattern domain by using specific algorithm when the real diffraction pattern image and the synthetic diffraction pattern image are prepared.

14. A system for converting a diffraction pattern image comprising:

a real diffraction pattern image refining unit configured to remove unnecessary information from real diffraction pattern image;
a synthetic diffraction pattern generating unit configured to obtain a synthetic diffraction pattern image corresponding to the real diffraction pattern image in which the unnecessary information is removed; and
an algorithm learning unit configured to generate a diffraction pattern image belonging to a synthetic diffraction pattern domain from a diffraction pattern image belonging to a real diffraction pattern domain by using a deep learning algorithm learned with at least one of the real diffraction pattern image and the synthetic diffraction pattern image.

15. A recording medium readable by a computer recording a program code, wherein the program code is used for performing a method comprising:

removing unnecessary information from real diffraction pattern image;
generating a synthetic diffraction pattern image corresponding to the real diffraction pattern image in which the unnecessary information is removed; and
generating an image belonging to real diffraction pattern domain from an image belonging to a synthetic diffraction pattern domain or generating the image belonging to the synthetic diffraction pattern domain from the image belonging to the real diffraction pattern domain by using at least one of the real diffraction pattern image in which the unnecessary image is removed and the synthetic diffraction pattern image.

FIG. 1

FIG. 2

**FIG. 3**

**FIG. 4**

**FIG. 5**

**FIG. 6**

**FIG. 7**

**FIG. 8**

HM:Im-3m #229
a=4.037Å
b=4.037Å
c=4.037Å
α=90.000°
β=90.000°
γ=90.000°

## FIG. 9

HM:P6_3/mmc #194
a=3.897Å
b=3.897Å
c=6.451Å
α=90.000°
β=90.000°
γ=120.000°

## FIG. 10

Starting point(0, 0, 0)

Scanning direction of an electron beam

HKL vector

Reciprocal lattice

Eward sphere

First order Laue zone (FOLZ)

Zero order Laue zone (ZOLZ)

Diffraction pattern

FIG. 11

FIG. 12

**FIG. 13**

**FIG. 14**

**FIG. 15**

**FIG. 16**

FIG. 17

FIG. 18

FIG. 19

FIG. 20

## INTERNATIONAL SEARCH REPORT

| International application No. |
| --- |
| **PCT/KR2022/015361** |

### A. CLASSIFICATION OF SUBJECT MATTER

**G06T 11/00**(2006.01)i; **G06T 3/40**(2006.01)i; **G06N 3/08**(2006.01)i

According to International Patent Classification (IPC) or to both national classification and IPC

### B. FIELDS SEARCHED

Minimum documentation searched (classification system followed by classification symbols)

G06T 11/00(2006.01); B25J 19/02(2006.01); B25J 9/16(2006.01); G01B 15/04(2006.01); G01N 21/00(2006.01); G01N 23/20(2006.01); G06T 7/00(2006.01); H01J 37/21(2006.01); H01J 37/28(2006.01); H04N 13/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 딥러닝(deep learning), 가상(imaginary), 회절(diffraction), 패턴(pattern), 도메인(domain), 실제(real), 변환(conversion), 알고리즘(algorithm), 학습(learning), TEM(Transmission Electron Microscope), SADP(Selected Area Diffraction Pattern), hole-filling, 격자 상수(lattice constant), CIF(Crystallography Information File), FHI-aims, 정대축(zone axis), 파라미터(parameter), 시료(sample), HOLZ(Higher Order Laue Zone), slab, Real2Sim, Sim2Real

### C. DOCUMENTS CONSIDERED TO BE RELEVANT

| Category* | Citation of document, with indication, where appropriate, of the relevant passages | Relevant to claim No. |
| --- | --- | --- |
| Y | KR 10-2111124 B1 (WEAREFRIENDS CO., LTD.) 15 May 2020 (2020-05-15)<br>See paragraphs [0037]-[0042], [0045] and [0048]; and figure 1. | 1-6,9-15 |
| A | | 7-8 |
| Y | WO 2021-096561 A1 (GOOGLE LLC) 20 May 2021 (2021-05-20)<br>See paragraphs [0001] and [0059]-[0061]; and figures 1-2. | 1-6,9-15 |
| Y | KR 10-2021-0122161 A (FEI COMPANY) 08 October 2021 (2021-10-08)<br>See paragraphs [0001], [0006] and [0226]. | 2-6,9-11 |
| Y | KR 10-2015-0078359 A (LG DISPLAY CO., LTD.) 08 July 2015 (2015-07-08)<br>See paragraphs [0058]-[0059]; and figure 2. | 4 |

☑ Further documents are listed in the continuation of Box C.　　☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **02 February 2023** | **03 February 2023** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 404 142 A1**

<table>
<tr><td colspan="2" align="center">**INTERNATIONAL SEARCH REPORT**</td><td>International application No.<br>**PCT/KR2022/015361**</td></tr>
</table>

**C.     DOCUMENTS CONSIDERED TO BE RELEVANT**

| Category* | Citation of document, with indication, where appropriate, of the relevant passages | Relevant to claim No. |
|---|---|---|
| Y | WO 2020-214745 A1 (KLA CORPORATION) 22 October 2020 (2020-10-22)<br>See paragraphs [0056] and [0130]. | 5-6 |
| A | KR 10-2005-0029762 A (SAMSUNG ELECTRONICS CO., LTD.) 28 March 2005 (2005-03-28)<br>See claims 1-9. | 1-15 |

Form PCT/ISA/210 (second sheet) (July 2022)

## INTERNATIONAL SEARCH REPORT
### Information on patent family members

| International application No. |
| --- |
| **PCT/KR2022/015361** |

| Patent document cited in search report | | | Publication date (day/month/year) | Patent family member(s) | | | Publication date (day/month/year) |
| --- | --- | --- | --- | --- | --- | --- | --- |
| KR | 10-2111124 | B1 | 15 May 2020 | | None | | |
| WO | 2021-096561 | A1 | 20 May 2021 | CN | 114585487 | A | 03 June 2022 |
| | | | | EP | 4021687 | A1 | 06 July 2022 |
| KR | 10-2021-0122161 | A | 08 October 2021 | CN | 113466273 | A | 01 October 2021 |
| | | | | EP | 3901980 | A2 | 27 October 2021 |
| | | | | EP | 3901980 | A3 | 22 December 2021 |
| | | | | JP | 2021-163756 | A | 11 October 2021 |
| | | | | US | 11404241 | B2 | 02 August 2022 |
| | | | | US | 2021-0305012 | A1 | 30 September 2021 |
| KR | 10-2015-0078359 | A | 08 July 2015 | KR | 10-2180068 | B1 | 17 November 2020 |
| WO | 2020-214745 | A1 | 22 October 2020 | CN | 113677983 | A | 19 November 2021 |
| | | | | CN | 113677983 | B | 15 November 2022 |
| | | | | DE | 112020002023 | T5 | 05 January 2022 |
| | | | | IL | 287034 | A | 01 December 2021 |
| | | | | JP | 2022-529043 | A | 16 June 2022 |
| | | | | KR | 10-2021-0143922 | A | 29 November 2021 |
| | | | | SG | 11202111073 | A | 29 November 2021 |
| | | | | TW | 202104841 | A | 01 February 2021 |
| | | | | US | 2020-0335406 | A1 | 22 October 2020 |
| KR | 10-2005-0029762 | A | 28 March 2005 | JP | 2005-099020 | A | 14 April 2005 |
| | | | | US | 2005-0061974 | A1 | 24 March 2005 |

Form PCT/ISA/210 (patent family annex) (July 2022)